# NOUVEAU FASCICULE DE BREVET EUROPEEN

(11) **EP 1 834 366 B2**
(45) Date de publication et mention de la décision concernant l'opposition: **15.08.2018**
(45) Mention de la délivrance du brevet: 04.03.2009
(21) Numéro de dépôt: 05825267.7
(22) Date de dépôt: 05.12.2005
(51) Int. Cl.: H01M 2/10, G01R 11/04, G01R 21/00

(54) **DISPOSITIF D'ALIMENTATION A PILE POUR UN APPAREIL DE COMPTAGE D'ENERGIE, ET APPAREIL DE COMPTAGE D'ENERGIE**
BATTERIEBETRIEBENE EINRICHTUNG FÜR EINEN STROMZÄHLER UND STROMZÄHLER
BATTERY POWERED DEVICE FOR AN POWER METER AND THE POWER METER

(30) Priorité: 14.12.2004 FR 0452969
(43) Date de publication de la demande: 19.09.2007
(73) Titulaire: Itron France, 92130 Issy-les-Moulineaux (FR)
(72) Inventeur: DURANCEAU, Jean-François, F-86170 Avanton (FR); CHABANNE, Frédéric, F-86490 Beaumont (FR)
(74) Mandataire: Howson, Richard Giles Bentham
(86) Numéro de dépôt international: PCT/EP2005/056486
(87) Numéro de publication internationale: WO 2006/063953

(56) Documents cités:
- EP-A- 0 529 757
- DE-U1- 20 001 278
- US-A- 5 843 595
- US-A- 6 062 901

## Description

La présente invention concerne un dispositif d'alimentation à pile pour un appareil de comptage d'énergie et l'appareil de comptage d'énergie associé.

Dans le domaine des appareils de comptage, il est connu d'utiliser une pile de manière à pouvoir conserver un minimum de données en cas de coupure de courant, notamment l'heure et le jour, de façon à éviter toute erreur de facturation.

Les piles utilisées sont classiquement des piles au lithium, du type pile bouton, du fait de leur faible encombrement. Compte tenu de la durée de vie limitée de ce type de pile, une pile bouton n'est effectivement connectée électriquement au circuit qu'elle doit alimenter qu'au moment de la mise en service de l'appareil de comptage. En outre, il peut s'avérer nécessaire de réaliser un changement de pile sur l'appareil de comptage lorsque ce dernier est en fonctionnement.

Ces opérations doivent pouvoir être menées en toute sécurité pour l'opérateur de maintenance. C'est pourquoi il est déjà connu d'équiper un appareil de comptage d'un module d'alimentation de secours à pile mis en place et connecté électriquement dans l'appareil de comptage au moment de son installation. Un tel module existe par exemple dans le appareil de comptage électrique de référence SL7000 commercialisé par le Demandeur. Ce module se présente sous la forme d'un pré assemblage d'une pile bouton, de deux fils de connexion soudés sur la pile, et d'un connecteur relié aux deux fils, le connecteur étant destiné à coopérer avec une prise de connecteur placée dans le compteur. Une fois le module mis en place dans le compteur, une vis de plombage sécurise le module de façon à éviter toute fraude au niveau du compteur.

Un tel module est une pièce complexe, donc coûteuse, à réaliser. En effet, les deux fils de connexion et le connecteur doivent passer dans un tube isolant du module présentant une forme très effilée et complexe de manière à éviter qu'un usager puisse mettre le doigt sur la carte électronique. La connexion électrique entre le connecteur et la prise de connecteur doit être effectuée à l'aide d'un outil spécifique, ce qui rend l'opération délicate.

Par ailleurs, un tel module ne favorise pas un changement aisé et économique lorsque la pile est déchargée, puisque tout le module doit être dans ce cas remplacé.

DE 20001278 divulgue un boîtier comprenant une partie supérieure apte à recouvrir un module d'alimentation comprenant un support de pile et une pile, le module d'alimentation étant disposé dans un compartiment d'alimentation d'une base intermédiaire. La pile peut être positionnée dans le support de manière active ou pour le transport.

L'invention est définie selon les revendications ci-après .

La présente invention a pour but de proposer un nouveau dispositif d'alimentation à pile pour appareil de comptage d'énergie, ainsi qu'un appareil de comptage d'énergie équipé d'un tel dispositif, dans lequel seule la pile est à changer lorsqu'elle vient à être déchargée, et ce, tout en respectant les conditions de protection pour l'opérateur.

Pour ce faire la présente invention a pour premier objet un appareil de comptage d'énergie comprenant une carte de circuit imprimé, un dispositif d'alimentation à pile pour alimenter électriquement ladite carte de circuit imprimé et un couvercle de protection de ladite carte, caractérisé en ce que le dispositif d'alimentation comprend un support sur lequel ladite pile peut être placée de façon amovible, et en ce que ledit couvercle de protection comprend une ouverture au travers de laquelle ledit support peut être inséré et des moyens coopérant avec le support de façon à permettre le placement de la pile dans deux positions distinctes par rapport à la carte de circuit imprimé, une première position dite de stockage dans laquelle la pile est hors contact électrique avec ladite carte, et une seconde position dite d'utilisation dans laquelle la pile est en contact électrique avec ladite carte.

Avantageusement, ledit support est monté mobile en translation selon un axe orthogonal au plan de l'ouverture, au moins un mouvement de translation dudit support étant réalisé pour le passage de la pile entre sa position de stockage et sa position d'utilisation.

Dans un mode de réalisation préféré de l'invention, ledit support présente un premier logement et un second logement chacun apte à recevoir ladite pile de façon amovible dans un plan sensiblement parallèle au plan de l'ouverture et à la carte de circuit imprimé, lesdits moyens sont des moyens de maintien du support dans le couvercle dans une position stable d'utilisation, et le premier et le second logements sont agencés de façon à permettre, dans ladite position stable, de placer la pile dans la position de stockage ou d'utilisation selon que la pile est située dans le premier logement ou le second logement.

En outre, le module connu décrit précédemment présente également comme inconvénient d'être complètement indépendant de l'appareil de comptage avant montage, de sorte qu'il peut arriver, lors de l'installation de l'appareil de comptage par un opérateur, que le module ne soit pas présent avec l'appareil de comptage. La présente invention a également pour second but de prévoir un pré montage du dispositif d'alimentation dans l'appareil de comptage avant installation de façon à éviter toute absence du dispositif lors de l'installation effective de l'appareil de comptage. Ceci est atteint dans un mode particulièrement avantageux de l'invention, dans lequel ledit support comporte un ergot anti-retour destiné à coopérer avec une butée du couvercle pour empêcher le retrait du support une fois qu'il a été inséré au travers de l'ouverture.

La présente invention et les avantages qu'elle procure seront mieux compris au vu de la description suivante faite en référence aux figures annexées illustrant un mode de réalisation non limitatif de l'invention, et dans lesquelles :
- la figure 1 illustre une vue en perspective ainsi qu'un zoom des éléments constitutifs de l'invention, sans la présence de pile, dans un mode de réalisation possible et préféré;
- la figure 2 est une vue en perspective du support de la figure 1, toujours sans la pile;
- la figure 3 est une coupe transversale du support, toujours sans la pile;
- la figure 4 est une coupe transversale montrant la coopération du support et de l'ouverture du couvercle de protection;
- les figures 5a et 5b illustrent en coupe, deux positions du support au travers de l'ouverture, le support étant muni de la pile dans sa position de stockage;
- les figures 6a et 6b illustrent en coupe, deux positions du support au travers de l'ouverture, le support étant muni de la pile dans sa position d'utilisation.

Dans la description qui va suivre, on se reportera simultanément à l'ensemble des figures, certaines références n'apparaissant que sur certaines figures.

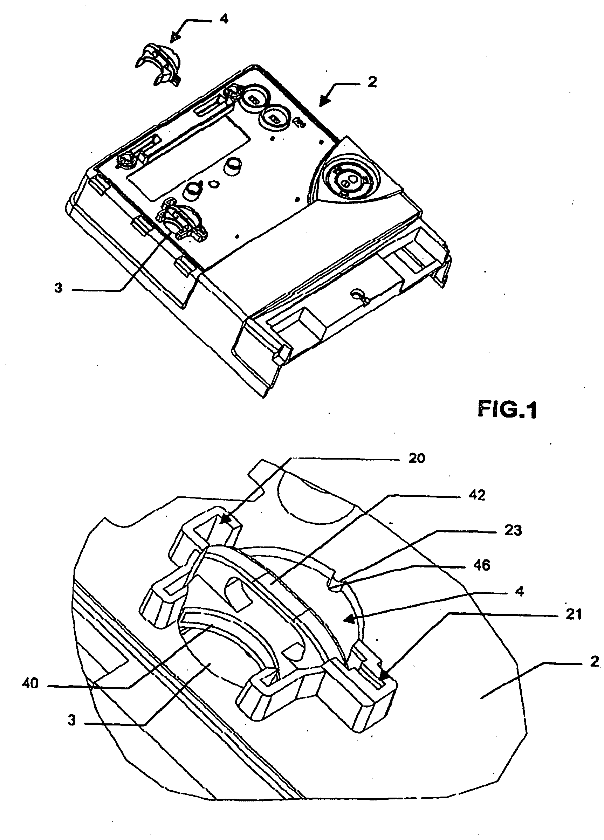

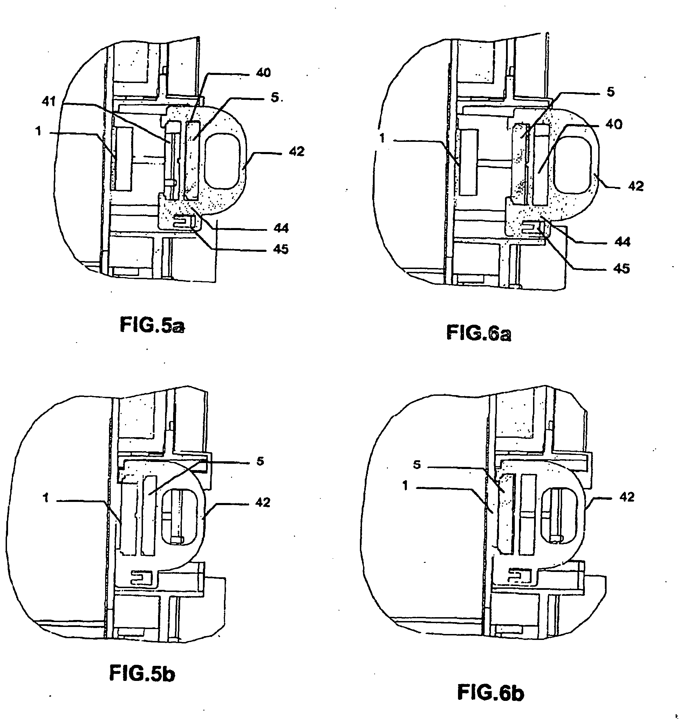

Un appareil de comptage d'énergie, par exemple un compteur électrique, comprend classiquement un boîtier, de forme générale extérieure sensiblement parallélépipédique, formé d'une base à l'intérieur de laquelle sont placés différents constituants, tels qu'un écran d'affichage et une carte de circuit imprimé 1 (voir figures 5a, 5b, 6a et 6b), d'une boîte de branchement pour permettre le raccordement du compteur au réseau général, et d'un couvercle de protection venant recouvrir l'ensemble constitué par la base et la boîte de branchement. Sur la figure 1, seul le couvercle de protection 2 d'un tel appareil de comptage a été représenté. Ce couvercle de protection forme une paroi externe qui s'étend sensiblement parallèlement et à distance du plan de la carte de circuit imprimé.

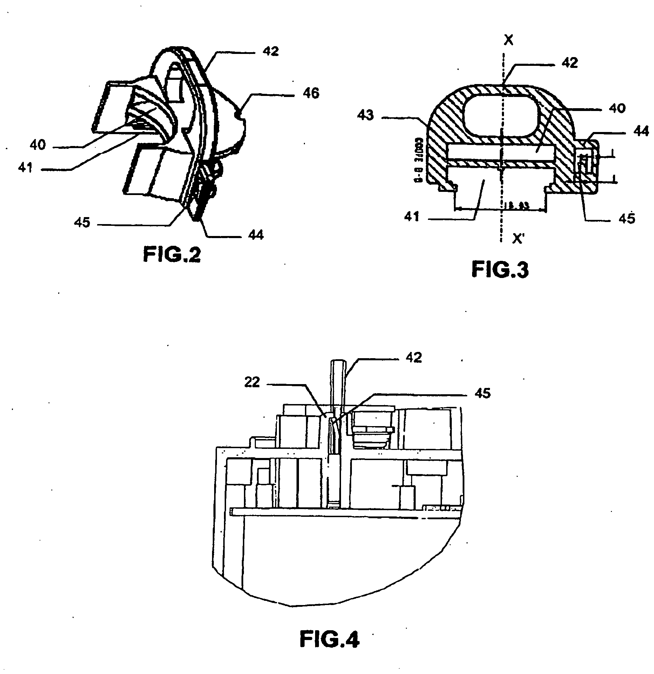

Ce couvercle de protection ou paroi externe présente une ouverture 3, sensiblement circulaire, au droit du lieu où se trouvent les connexions électriques (pistes conductrices ou autres) de la carte de circuit imprimée 1. Le dispositif d'alimentation à pile comporte un support 4 sur lequel une pile 5 peut être placée de façon amovible, ce support 4 pouvant être inséré au travers de l'ouverture 3. Plus précisément, dans l'exemple de réalisation décrit, et comme plus particulièrement visible sur les figures 2 et 3, le support 4 est une pièce en matériau isolant, venue par exemple de moulage, et présentant deux logements 40, 41, chacun apte à recevoir une pile de type bouton de manière amovible. Les deux logements sont superposés le long de l'axe X-X' correspondant à la direction d'introduction du support au travers de l'ouverture. Au-dessus des deux logements 40, 41, le support présente une partie de préhension 42 pour le maintien et la manoeuvre du support par un utilisateur dans l'ouverture. Le support comporte en outre deux extensions 43, 44 diamétralement opposées, ici dans le prolongement de la partie de préhension 42, s'étendant le long des deux logements, et destinées à coopérer avec deux rainures 20, 21 de forme complémentaire présentes sur le couvercle 2 au niveau de l'ouverture (voir figure 1), pour l'insertion et le guidage du support au travers de l'ouverture. L'une des extensions comporte avantageusement un ergot anti-retour 45 destiné à coopérer avec une butée 22 présente dans la rainure 21 du couvercle recevant cette extension pour empêcher le retrait du support une fois qu'il a été inséré. L'ergot 45 doit présenter suffisamment d'élasticité pour permettre une insertion du support dans l'ouverture.

Au moment de la fabrication ou de la livraison d'un appareil de comptage, le support 4 est monté sur l'appareil de comptage par insertion au travers de l'ouverture 3. Sur la figure 1, on voit que le support 4 d'une part, et le couvercle de protection 2 d'autre part, comportent avantageusement des moyens de détrompage, et une forme de maintien en position de la pile référencés 46 et 23, destinés à éviter toute erreur dans le positionnement du support. Une fois que le support a été inséré au travers de l'ouverture du couvercle de protection, la partie de préhension 42 doit faire saillie par rapport à la surface du couvercle de manière à rester accessible pour l'utilisateur. Comme on l'a vu précédemment, le support 4 ne peut de préférence plus être extrait de l'ouverture du fait de l'ergot anti-retour 45. Cela permet d'éviter, ou à tout le moins de réduire les risques que le dispositif d'alimentation de secours soit absent lors de l'installation de l'appareil de comptage. L'utilisateur peut cependant faire subir au support un mouvement de translation limité par l'ergot anti-retour, le long de l'axe X-X', de manière à faire sortir suffisamment le support et accéder à l'un ou l'autre des logements 40, 41 du support. Cette position du support est illustrée sur les figures 5a et 6a. L'utilisateur peut ainsi insérer ou extraire une pile 5 de l'un ou l'autre des logements 40, 41. Lorsque l'utilisateur relâche la partie de préhension 42, le support reprend la position illustrée dans les figures 5b et 5c.

Tant que l'appareil de comptage équipé du support n'est pas installé, la pile 5 sera avantageusement placée dans le logement 40, de manière à être dans sa position de stockage. Cette position est illustrée sur la figure 5b où l'on voit que la pile 5 n'est pas en contact électrique avec la carte du circuit imprimé 1. Au moment de l'installation proprement dite de l'appareil de comptage, c'est-à-dire de son raccordement au réseau, l'opérateur peut manoeuvrer à nouveau le support 4 pour extraire la pile 5 du logement 40 et la placer dans le logement 41 qui correspond à la position d'utilisation de la pile. Cette position est illustrée sur la figure 6b où l'on voit que la pile 5 est en contact électrique avec la carte du circuit imprimé 1. Lorsque la pile est usée, il suffit de manoeuvrer à nouveau le support pour extraire la pile usée du logement 41 et la remplacer par une pile neuve.

D'autres formes de réalisation sont envisageables sans départir du cadre de la présente invention. Notamment, il est possible de ne prévoir qu'un seul logement au niveau du support susceptible d'accepter une pile de façon amovible. Dans ce cas, il faut prévoir au niveau du support et au niveau du couvercle des moyens mécaniques coopérant entre eux pour permettre à un utilisateur de faire subir au support un mouvement de translation entre deux positions stables : une première position dans laquelle la pile reçue dans le logement sera dans sa position d'utilisation, c'est-à-dire en contact électrique avec la carte de circuit imprimé, et une seconde position dans laquelle la pile reçue dans le logement sera dans sa position de stockage, c'est-à-dire sans contact électrique avec la carte de circuit imprimé.

En conclusion, les différents modes de réalisation décrits précédemment permettent un changement aisé et sans danger de la pile lorsque cette dernière est usée. En outre, avec la présence avantageuse de l'ergot anti-retour, le dispositif d'alimentation est imperdable. De plus, dans ce cas, l'utilisateur ne peut retirer le dispositif, ce qui diminue les risque de fraudes. Un autre avantage de l'invention réside dans le fait que l'ouverture est suffisamment importante pour permettre, avant que le dispositif ne soit mis en place, un accès aisé à la carte de circuit imprimé, qui peut être nécessaire lors du contrôle du fonctionnement de l'appareil de comptage.

## Revendications

1. Appareil de comptage d'énergie comprenant une carte de circuit imprimé (1), un dispositif d'alimentation à pile pour alimenter électriquement ladite carte de circuit imprimé et un couvercle (2) de protection de ladite carte, **caractérisé en ce que** le dispositif d'alimentation comprend un support (4) sur lequel ladite pile (5) peut être placée de façon amovible, et **en ce que** ledit couvercle (2) de protection comprend une ouverture (3) au travers de laquelle ledit support peut être inséré et des moyens (20-22) coopérant avec le support de façon à permettre le placement de la pile (5) dans deux positions distinctes par rapport à la carte de circuit imprimé (1), une première position dite de stockage dans laquelle la pile (5) est hors contact électrique avec ladite carte (1), et une seconde position dite d'utilisation dans laquelle la pile (5) est en contact électrique avec ladite carte (1).

2. Appareil de comptage d'énergie selon la revendication 1, **caractérisé en ce que** ledit support (4) est monté mobile en translation selon un axe (XX') orthogonal au plan de l'ouverture (3), au moins un mouvement de translation dudit support étant réalisé pour le passage de la pile (5) entre sa position de stockage et sa position d'utilisation.

3. Appareil de comptage d'énergie selon la revendication 2, **caractérisé en ce que** ledit support présente un logement apte à recevoir la pile de façon amovible dans un plan sensiblement parallèle au plan de l'ouverture et à la carte de circuit imprimé, et **en ce que** ledit couvercle comporte des moyens mécaniques autorisant le mouvement de translation du support entre deux positions stables, une position dans laquelle la pile, si présente dans le logement, est dans sa position dite de stockage, et une seconde position dans laquelle la pile, si présente dans le logement, est dans sa position dite d'utilisation.

4. Appareil de comptage d'énergie selon la revendication 2, **caractérisé en ce que** ledit support (4) présente un premier logement (40) et un second logement (41) chacun apte à recevoir ladite pile (5) de façon amovible dans un plan sensiblement parallèle au plan de l'ouverture (3) et à la carte de circuit imprimé (1), **en ce que** lesdits moyens sont des moyens de maintien du support dans le couvercle dans une position stable d'utilisation, et **en ce que** le premier et le second logements (40, 41) sont agencés de façon à permettre, dans ladite position stable, de placer la pile dans la position de stockage ou d'utilisation selon que la pile est située dans le premier logement (40) ou le second logement (41).

5. Appareil de comptage d'énergie selon la revendication 4, **caractérisé en ce que** ledit support (4) comporte une partie de préhension (42) pour le maintien et la manoeuvre du support dans l'ouverture par un utilisateur.

6. Appareil de comptage d'énergie selon la revendication 5, **caractérisé en ce que** ledit support (4) comporte en outre deux extensions (43, 44) diamétralement opposées, dans le prolongement de ladite partie de préhension (42), destinées à coopérer avec deux rainures (20, 21) du couvercle (2) pour l'insertion et le guidage du support (4) au travers de l'ouverture (3).

7. Appareil de comptage d'énergie selon l'une quelconque des revendications précédentes, **caractérisé en ce que** ledit support (4) comporte un ergot anti-retour (45) destiné à coopérer avec une butée (22) du couvercle pour empêcher le retrait du support (4) une fois qu'il a été inséré au travers de l'ouverture.

## Patentansprüche

1. Energiezähler, umfassend eine Leiterplatte (1), eine Batterie-Stromversorgungsvorrichtung, um die Leiterplatte mit Strom zu versorgen, und einen Deckel (2) zum Schutz der Platte, **dadurch gekennzeichnet, dass** die Stromversorgungsvorrichtung einen Halter (4) umfasst, auf dem die Batterie (5) abnehmbar angeordnet werden kann, und dass der Schutzdeckel (2) eine Öffnung (3) umfasst, durch die der Halter eingeführt werden kann, und Mittel (20-22), die mit dem Halter derart zusammenwirken, dass die Batterie (5) relativ zur Leiterplatte (1) in zwei verschiedene Positionen gebracht werden kann, eine erste sogenannte Aufbewahrungsposition, in der die Batterie (5) keinen elektrischen Kontakt mit der Platte hat (1), und eine zweite sogenannte Gebrauchsposition, in der die Batterie (5) mit der Platte (1) in elektrischem Kontakt steht.

2. Energiezähler nach Anspruch 1, **dadurch gekennzeichnet, dass** der Halter (4) entlang einer Achse (XX'), welche orthogonal zur Ebene der Öffnung (3) verläuft, verschiebbar angeordnet ist, wobei mindestens eine Verschiebungsbewegung des Halters ausgeführt wird, um die Batterie (5) zwischen ihrer Aufbewahrungsposition und ihrer Gebrauchsposition zu überführen.

3. Energiezähler nach Anspruch 2, **dadurch gekennzeichnet, dass** der Halter eine Aufnahme aufweist, die in der Lage ist, die Batterie in einer Ebene, die im Wesentlichen zur Ebene der Öffnung und zur Leiterplatte parallel ist, abnehmbar aufzunehmen, und dass der Deckel mechanische Mittel aufweist, welche die Verschiebebewegung des Halters zwischen zwei feststehenden Positionen erlauben, und zwar eine Position, in der sich die Batterie, falls sie in der Aufnahme vorhanden ist, in ihrer so genannten Aufbewahrungsposition befindet, und eine zweite Position, in der sich die Batterie, falls sie in der Aufnahme vorhanden ist, in ihrer so genannten Gebrauchsposition befindet.

4. Energiezähler nach Anspruch 2, **dadurch gekennzeichnet, dass** der Halter (4) eine erste Aufnahme (40) und eine zweite Aufnahme (41) aufweist, die jeweils angepasst sind, um die Batterie (5) in einer Ebene, die im Wesentlichen zur Ebene der Öffnung (3) und zur Leiterplatte (1) parallel ist, abnehmbar aufzunehmen, und dass die Mittel Mittel zum Festhalten des Halters in dem Deckel in einer feststehenden Gebrauchsposition sind, und dass die erste Aufnahme und die zweite Aufnahme (40, 41) derart angeordnet sind, dass sie es in der feststehenden Position erlauben, die Batterie in die Aufbewahrungs- oder Gebrauchsposition zu setzen, je nachdem ob die Batterie sich in der ersten Aufnahme (40) oder in der zweiten Aufnahme (41) befindet.

5. Energiezähler nach Anspruch 4, **dadurch gekennzeichnet, dass** der Halter (4) ein Griffteil (42) umfasst zum Festhalten und Manipulieren des Halters in der Öffnung durch einen Benutzer.

6. Energiezähler nach Anspruch 5, **dadurch gekennzeichnet, dass** der Halter (4) ferner zwei genau entgegengesetzte Erweiterungen (43, 44) in der Verlängerung des Griffteils (42) umfasst, die dazu gedacht sind, mit zwei Nuten (20, 21) des Deckels (2) zusammenzuwirken, um den Halter (4) durch die Öffnung (3) einzuschieben und zu führen.

7. Energiezähler nach einem der vorhergehenden Ansprüche, **dadurch gekennzeichnet, dass** der Halter (4) eine Rücksetzsperre (45) umfasst, die dazu gedacht ist, um mit einem Anschlag (22) des Deckels zusammenzuwirken, um ein Herausnehmen des Halters (4) zu verhindern, nachdem er durch die Öffnung eingeschoben wurde.

## Claims

1. An energy metering apparatus, comprising a printed circuit board (1), a battery power supply device for powering said printed circuit board, and a lid (2) for protecting said board, **characterized in that** the power supply device comprises a bracket (4) on which said battery (5) can be placed removably, and that said protective lid (2) comprises an opening (3) through which said bracket can be inserted, and means (20-22) cooperating with the bracket so as to allow for the battery (5) to be placed in two different positions with respect to the printed circuit board (1), a first so-called storage position wherein the battery (5) has no electrical contact with said board (1), and a second so-called operating position wherein the battery (5) is in electrical contact with said board (1).

2. The energy metering apparatus according to claim 1, **characterized in that** said bracket (4) is mounted to be mobile in translation along an axis (XX') orthogonal to the plane of the opening (3), with at least one translatory motion of said bracket being made for shifting the battery (5) between the storage position thereof and the operating position thereof.

3. The energy metering apparatus according to claim 2, **characterized in that** said bracket has a housing capable of removably receiving the battery in a plane substantially parallel to the plane of the opening and the printed circuit board, and that said lid has mechanical means allowing for the translatory motion of the bracket between two stable positions, a position wherein the battery, if present in the housing, is in the so-called storage position thereof, and a second position wherein the battery, if present in the housing, is in the so-called operating position thereof.

4. The energy metering apparatus according to claim 2, **characterized in that** said bracket (4) has a first housing (40) and a second housing (41), each capable of removably receiving said battery (5) in a plane substantially parallel to the plane of the opening (3) and the printed circuit board (1), and that said means are means for holding the bracket in the lid in a stable operating position, and that the first and second housings (40, 41) are arranged so as to allow, in said stable position, for the battery to be placed in the storage or operating position according to whether the battery is located in the first housing (40) or the second housing (41) .

5. The energy metering apparatus according to claim 4, **characterized in that** said bracket (4) comprises a gripping part (42) for holding and handling of the bracket in the opening by a user.

6. The energy metering apparatus according to claim 5, **characterized in that** said bracket (4) further comprises two diametrically opposed extensions (43, 44) extending said gripping part (42), designed for cooperating with two grooves (20, 21) of the lid (2) for inserting and guiding the bracket (4) through the opening (3).

7. The energy metering apparatus according to any of the preceding claims, **characterized in that** said bracket (4) comprises a non-return lug (45) designed for cooperating with a stop (22) of the lid in order to prevent withdrawal of the bracket (4) after it has been inserted through the opening.
